(19) Europäisches Patentamt
European Patent Office
Office européen des brevets

(11) **EP 2 667 206 A1**

(12) **EUROPEAN PATENT APPLICATION**
published in accordance with Art. 153(4) EPC

(43) Date of publication:
**27.11.2013 Bulletin 2013/48**

(51) Int Cl.:
***G01R 19/00*** (2006.01)

(21) Application number: **12736745.6**

(22) Date of filing: **13.01.2012**

(86) International application number:
**PCT/JP2012/050629**

(87) International publication number:
**WO 2012/099022 (26.07.2012 Gazette 2012/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.01.2011 JP 2011007033**

(71) Applicant: **Kabushiki Kaisha Toshiba**
**Minato-ku**
**Tokyo 105-8001 (JP)**

(72) Inventors:
• **KOSHIZUKA, Tadashi**
**Tokyo 105-8001 (JP)**
• **KUDO, Kietsu**
**Tokyo 105-8001 (JP)**
• **NAKAMOTO, Tetsuya**
**Tokyo 105-8001 (JP)**

(74) Representative: **Willquist, Sofia Ellinor**
**Awapatent AB**
**Junkersgatan 1**
**582 35 Linköping (SE)**

(54) **TRANSIENT RECOVERY VOLTAGE MEASURING DEVICE, TRANSIENT RECOVERY VOLTAGE MEASURING METHOD, AND TRANSIENT RECOVERY VOLTAGE MEASURING PROGRAM**

(57) A common tangent line drawn between a rise portion present from the origin to a second reference voltage and a rise portion corresponding to the second reference voltage can be easily generated through a waveform conversion. A transient recovery voltage measuring device includes a memory storing a transient recovery voltage waveform of a multiple frequency, a waveform conversion unit converting the transient recovery voltage waveform, a wave height determination unit determining two points having the same maximum value on the converted waveform, an adjustment unit adjusting the proportional constant of the waveform conversion unit to determine those two points by the wave height determination unit, a contact point detection unit obtaining two points corresponding to the determined two points determined by the wave height determination unit, and a tangent line generation unit generating a first tangent line passing through the detected two points on the transient recovery voltage waveform.

FIG. 2

1 TRANSIENT RECOVERY VOLTAGE MEASURING DEVICE

EP 2 667 206 A1

**Description**

FIELD

An embodiment of the present invention relates to a transient recovery voltage measuring device, a transient recovery voltage measuring method and a transient recovery voltage measuring program which draw a tangent line in a transient recovery voltage waveform to obtain, for example, a parameter of a transient recovery voltage occurred after a breaker interrupts a current.

BACKGROUND

After a breaker interrupts a current, a voltage appears between contacts of the breaker. This voltage is called a transient recovery voltage. The transient recovery voltage has a waveform of a single frequency or a multiple frequency. A parameter for expressing a transient recovery voltage, such as a second reference voltage and a rate of rise, can be read from such a waveform.

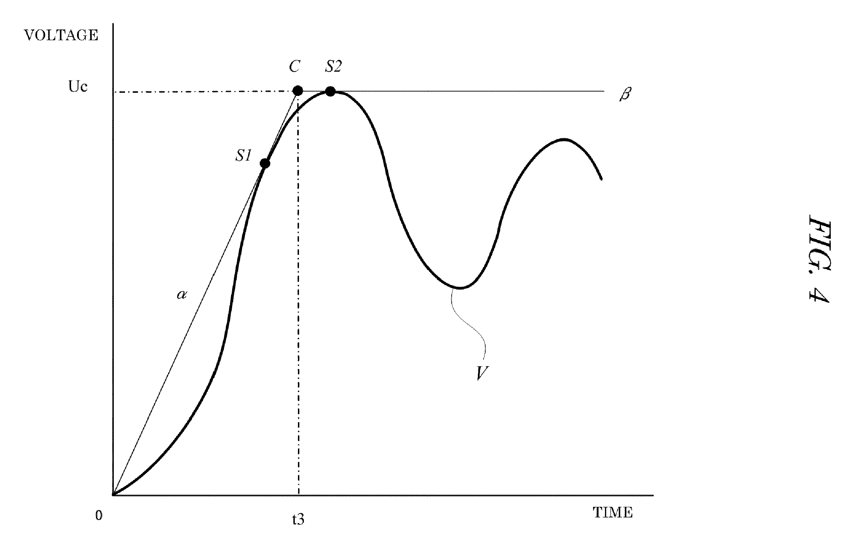

A transient recovery voltage is expressed through the two-parameter technique in the case of a single frequency waveform. According to this two-parameter technique, a transient recovery voltage can be expressed with two parameters: a second reference voltage; and a time to reach the first reference voltage (or a rate of rise). These two parameters are obtained through a scheme illustrated in FIG. 4. First, a tangent line $\alpha$ is drawn from the origin to a transient recovery voltage waveform V. The contact point in this case is taken as S1. Next, at the peak (in this case, a wave height part (wave height value Uc)) of the transient recovery voltage waveform V, a tangent line $\beta$ is drawn in parallel with the time axis. The contact point in this case is taken as S2. An intersection point C between the tangent line $\alpha$ and the tangent line $\beta$ is obtained. The time corresponding to this intersection point C is a time to reach the first reference voltage t3.

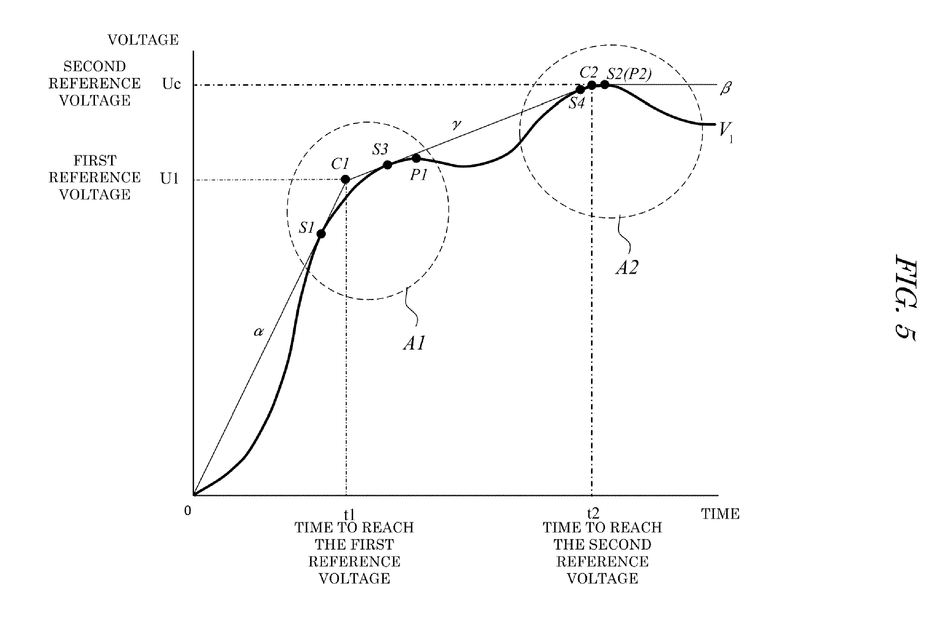

Conversely, a transient recovery voltage is expressed through the four-parameter technique in the case of a multiple frequency waveform. According to this four-parameter technique, a transient recovery voltage can be expressed with four parameters: a first reference voltage; a time to reach the first reference voltage (or an initial rate of rise); a second reference voltage; and a time to reach the second reference voltage. These four parameters are obtained through a scheme illustrated in FIG. 5. First, in addition to the respective tangent lines $\alpha$ and $\beta$ of the above-explained two-parameter technique, a common tangent line $\gamma$ is drawn between a rise portion A1 present between the origin and a wave height part, and, a rise portion A2 corresponding to the wave height part. Next, intersection points C1 and C2 between the common tangent line $\gamma$ and the respective tangent lines $\alpha$ and $\beta$ are obtained. The intersection point C1 between the tangent line $\alpha$ and the common tangent line $\gamma$ indicates a first reference voltage U1 and a time to reach the first reference voltage t1. The intersection point C2 between the tangent line $\beta$ and the common tangent line $\gamma$ indicates a second reference voltage Uc and a time to reach the second reference voltage t2.

In FIG. 5, S3 indicates a contact point between the rise portion A1 and the common tangent line $\gamma$. P1 indicates the peak of the rise portion A1. S4 indicates a contact point between the rise portion A2 and the common tangent line $\gamma$. P2 indicates the peak of the rise portion A2, and is common to the contact point S2 with the tangent line $\beta$.

Non-Patent Document 1: The Institute of Electrical Engineers of Japan, Japanese Electrotechnical Committee Standard, AC breaker, JEC-2300-1998

An inclination of a tangent line of a given curve is a differential value of the curve. Hence, when a common tangent line between two points on a curve is drawn, it is necessary to obtain two points that have the same differential value of the curve. However, a straight line passing through such two points having the same differential value includes, not commonly, two straight lines in parallel with each other. Accordingly, it is not always true that the line drawn between the two points having the same differential value is a common tangent line. Hence, drawing of a common tangent line between two points on a curve is generally difficult. In particular, when calculation is performed by a computer, a load of calculation becomes highly possibly enormous.

In view of the above-explained conventional technology, an object to be accomplished by the invention is to provide a transient recovery voltage measuring device, a transient recovery voltage measuring method, and a transient recovery voltage measuring program which easily generate a common tangent line drawn between a rise portion present from the origin to a wave height part and a rise portion corresponding to a wave height part in order to obtain a parameter of a transient recovery voltage from a transient recovery voltage waveform of a multiple frequency.

In order to solve the above-mentioned problem, an embodiment of a transient recovery voltage measuring device is characterized by employing the following structure:

(1) a waveform memory that stores a transient recovery voltage waveform of a multiple frequency;
(2) a waveform conversion unit that converts the transient recovery voltage waveform based on a proportional value obtained by multiplying a time from an origin by a proportional constant;
(3) a wave height determination unit that determines two points having a same maximum value on a converted waveform;

(4) an adjustment unit that adjusts the proportional constant of the waveform conversion unit until two points having the same maximum value are determined by the wave height determination unit;

(5) a contact point detection unit that detects two points on the transient recovery voltage waveform corresponding to two points determined by the wave height determination unit; and

(6) a first tangent line generation unit that generates a first tangent line passing through the two points detected by the contact point detection unit.

Additionally, the present invention may be regarded as a method and a program of a computer or an electronic circuit for realizing the function of each of the above-mentioned units.

According to the above-explained embodiment, a tangent line drawn between a rise portion present from the origin to a second reference voltage and a rise portion corresponding to the second reference voltage can be easily generated using a waveform conversion based on a value proportional to time from the origin.

BRIEF DESCRIPTION OF THE DRAWINGS

FIG. 1 is an explanatory diagram for explaining a tangent line generating processing according to an embodiment;

FIG. 2 is a block diagram illustrating an example transient recovery voltage measuring device according to an embodiment;

FIG. 3 is a flow chart illustrating an example processing according to an embodiment;

FIG. 4 is an explanatory diagram illustrating how to obtain a parameter through a two-parameter technique; and

FIG. 5 is an explanatory diagram illustrating how to obtain a parameter through a four-parameter technique.

DETAILED DESCRIPTION

[1. Principle of Obtaining Tangent Line]

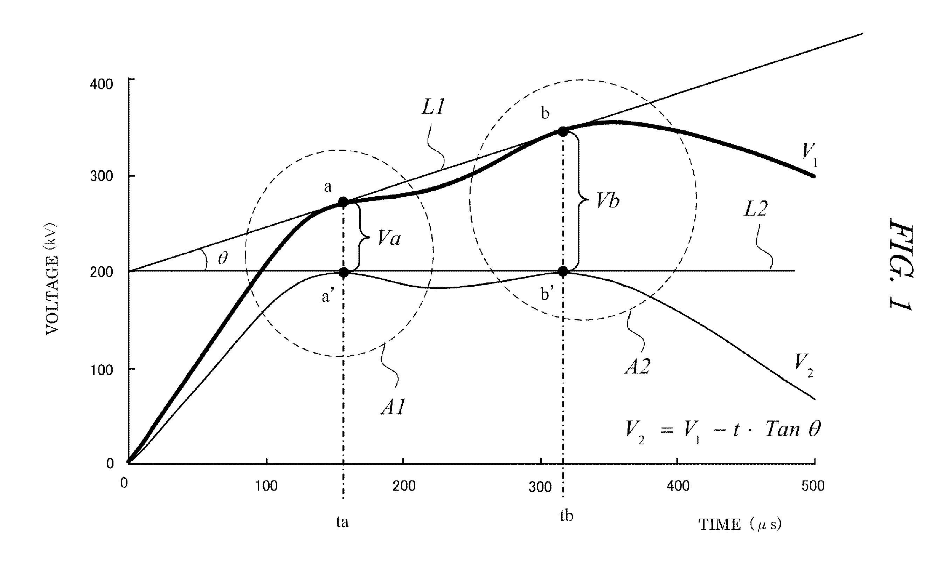

FIG. 1 is a diagram for explaining a principle of obtaining a tangent line according to an embodiment. In the figure, $V_1$ indicates a waveform of a multiple frequency. For example, $V_1$ can be regarded as a waveform of a transient recovery voltage (TRV) after a breaker current is interrupted. In the case of the voltage waveform, for example, a horizontal axis (X axis) indicates a time ($\mu$s), while a vertical axis (Y axis) indicates a voltage (kV). $V_2$ is a waveform obtained by converting the waveform $V_1$ with the following formula (1).

(Formula 1)

$$V_2 = V_1 - t \times \mathrm{Tan}\theta \qquad \mathrm{Formula}\ (1)$$

In formula (1), an angle $\theta$ is given, and a value obtained by multiplying a tangent of the given angle by a time (a proportional value) is subtracted from $V_1$. As will be discussed later, $\mathrm{Tan}\theta$ can be regarded as a proportional constant.

In the figure, L1 indicates a tangent line (a first tangent line to be discussed later) which is a main target of this embodiment. This tangent line L1 is drawn on the waveform $V_1$ between a rise portion A1 present between the origin and a wave height part and a rise portion A2 corresponding to the wave height.

In the figure, L2 indicates a tangent line in contact with two points when the waveform $V_2$ obtained by converting the waveform $V_1$ becomes to have the two points with the same maximum value (peak value).

On the waveform $V_1$, it is presumed that when the above-explained tangent line L1 is drawn, two points that are contacting points are points a and b. These two points become points a' and b', respectively, on the converted waveform $V_2$. The points a' and b' have the same horizontal axis values ta, tb as those of the original points a and b. That is, the vertical axis values of the points a' and b' are values obtained respectively by subtracting Va from the value of the point a and by subtracting Vb from the value of the point b. Hence, when the angle $\theta$ in the figure is set appropriately, the tangent line L2 drawn between the point a' and the point b' becomes in parallel with the horizontal axis.

Accordingly, the angle $\theta$ of the waveform $V_2$ that is obtained by converting the waveform $V_1$ through the formula (1) is adjusted in such a way that the values of the points a' and b' become the same, thereby obtaining the values ta and tb. In this case, ta and tb become the horizontal axis values of the points a and b in contact with the tangent line L1 on the original waveform $V_1$. This makes the values of the points a and b known on the original waveform $V_1$, and thus the tangent line L1 can be easily drawn.

3

Conversely, as explained in background, a tangent line $\alpha$ (a second tangent line to be discussed later) from the origin to the waveform $V_1$ and a tangent line $\beta$ (a third tangent line to be discussed later) in parallel with the horizontal axis at the second reference voltage can be easily drawn. Hence, when all tangent lines are drawn through a four-parameter technique, from the respective intersection points thereof, respective parameters of a TRV can be calculated: a first reference voltage; a time to reach the first reference voltage; a second reference voltage; and a time to reach the second reference voltage.

[2. Structure of Embodiment]

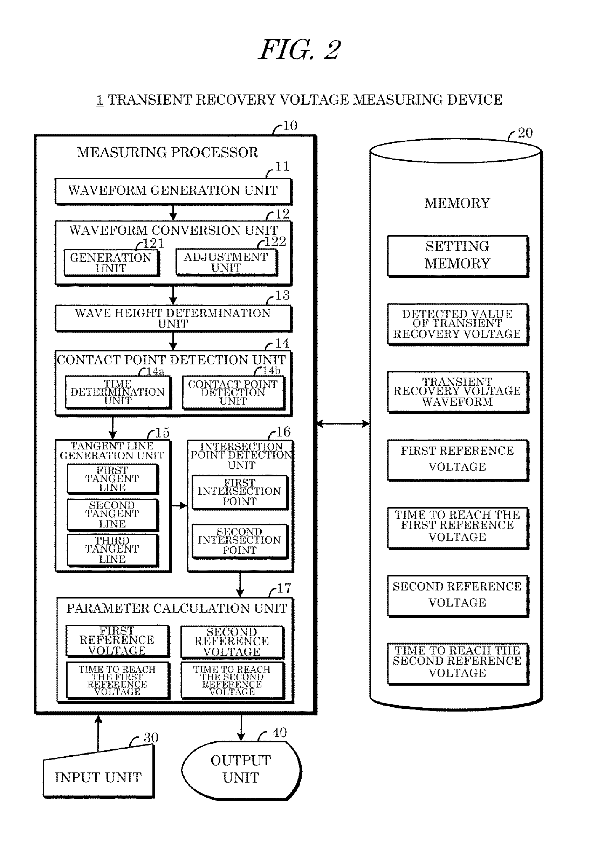

Next, an explanation will be given of a structure of an embodiment for generating a tangent line and obtaining each parameter in accordance with the above-explained principle. As illustrated in FIG. 2, a transient recovery voltage measuring device 1 of this embodiment can be realized by controlling a computer with a predetermined program or by an exclusive electronic circuit. The program in this case realizes the process of each unit to be discussed later by physically utilizing the computer hardware. An aspect of the present embodiment also includes a method and a program for executing the process of each unit, and a recording medium having stored therein such a program. Moreover, how to set the processing range of hardware and the processing range of software including the program are not limited to any particular aspect.

The transient recovery voltage measuring device 1 includes a measuring processor 10, a memory 20, an input unit 30, and an output unit 40, etc. The measuring processor 10 includes a waveform generation unit 11, a waveform conversion unit 12, a wave height determination unit 13, a contact point detection unit 14, a tangent line generation unit 15, an intersection point detection unit 16, and a parameter calculation unit 17, etc., which are activated upon execution of the above-explained program.

The waveform generation unit 11 is a processing unit which generates a transient recovery voltage waveform based on a detected value of a transient recovery voltage. The waveform conversion unit 12 is a processing unit which converts a transient recovery voltage waveform. This waveform conversion unit 12 has a generation unit 121 and an adjustment unit 122, etc.

The generation unit 121 is a processing unit that generates a waveform obtained by converting a transient recovery voltage waveform through a calculation based on a predetermined formula. In this embodiment, for example, a calculation based on the above-explained formula (1) is executed. The adjustment unit 122 is a processing unit which changes a parameter of the predetermined formula in such a way that a waveform to be generated by the generation unit 121 changes. In this embodiment, for example, a process for changing $\theta$ in the formula (1) is executed.

The wave height determination unit 13 is a processing unit which determines whether or not there are two points having the same maximum value (peak value) in a waveform converted by the waveform conversion unit 12. The contact point detection unit 14 is a processing unit which detects two points on a transient recovery voltage waveform which are corresponding to the two points determined by the wave height determination unit 13. In this embodiment, for example, the contact point detection unit 14 has functions as a time determination unit 14a and a contact point determination unit 14b. The time determination unit 14a is a processing unit which determines times of the two points determined by the wave height determination unit 13. The contact point determination unit 14b is a processing unit which determines two points on a transient recovery voltage waveform corresponding to the times determined by the time determination unit 14a.

The tangent line generation unit 15 is a processing unit which generates a tangent line necessary for a four-parameter technique. This tangent line generation unit 15 generates a first tangent line, a second tangent line and a third tangent line. Hence, the tangent line generation unit 15 has functions as a first tangent line generation unit, a second tangent line generation unit and a third tangent line generation unit. The first tangent line is a tangent line (the above-explained tangent line L1) passing through the two points obtained by the contact point detection unit 14. The second tangent line is a tangent line (the above-explained tangent line $\alpha$) running from the origin to a transient recovery voltage waveform. The third tangent line is a tangent line (the above-explained tangent line $\beta$) having the maximum value (peak value) on a transient recovery voltage waveform as a contact point and in parallel with the time axis. The generation of the second and the third tangent lines is a conventionally well-known art, and the explanation thereof is omitted.

The intersection point detection unit 16 is a processing unit which detects intersection points between the first tangent line, the second tangent line and the third tangent line. This intersection point detection unit 16 detects a first intersection point and a second intersection point. Hence, the intersection point detection unit 16 has functions as a first intersection point detection unit and a second intersection point detection unit. The first intersection point is an intersection point between the first tangent line and the second tangent line. The second intersection point is an intersection point between the first tangent line and the third tangent line.

The parameter calculation unit 17 is a processing unit which calculates four parameters (parameters) of a four-parameter technique. Hence, the parameter calculation unit 17 has functions as a first reference voltage calculation unit, a time to reach the first reference voltage (or an initial rate of rise) calculation unit, a second reference voltage calculation unit, and a time to reach the second reference voltage calculation unit. A first reference voltage and a time to reach the first reference voltage can be obtained from the first intersection point. A second reference voltage and a time to reach the second reference voltage can be obtained from the second intersection point. These techniques are conventionally well-known art, and the explanation thereof is omitted.

The memory 20 is a component which stores various information, such as data necessary for the process by the measuring processor 10, detected values, calculation results, and generated data. Regarding a transient recovery voltage waveform, either one generated by the waveform generation unit 11 or one generated at the exterior in advance and input may be stored. That is, according to this embodiment, it is appropriate if a transient recovery voltage waveform be stored in such a way that the measuring processor 10 becomes an operable condition. An area having such a transient recovery voltage waveform stored therein has a function as a waveform memory.

Moreover, the memory 20 is also built with a setting memory which stores various settings necessary for the process by the measuring processor 10. These settings include, for example, standards for various processes, such as a calculation formula, a default value of a parameter to be used for the calculation formula, a change level of such a default value. Information to be stored in the memory 20 may be information input from the exterior via, for example, the input unit 30.

The memory 20 may be typically various memories, a hard disk, and an optical disk, etc. that are built-in or externally connected, but all recording media available in present or in future are applicable. A register and the like used for a calculation may also be regarded as the memory 20. A recording medium having information already stored therein may be loaded in a reading device so as to be available to the measuring processor 10.

The input unit 30 is a component which inputs information necessary for the transient recovery voltage measuring device 1, as well as a selection of a process and an instruction. Example input units 30 are a keyboard, a mouse, and a touch panel (including one structured on a display device). However, all input devices available in present or in future can be applicable. Moreover, the input unit 30 includes an interface and the like which receives input from wirings for normal monitoring and communication networks

The output unit 40 is a component which outputs various data, a transient recovery voltage waveform, a converted waveform, a tangent line, an intersection point, and a calculated parameter, etc., in a manner recognizable by users including a manager and an operator. Example output units 40 are a display device and a printer. However, all output devices available in present or in future can be applicable.

[3. Action of Embodiment]

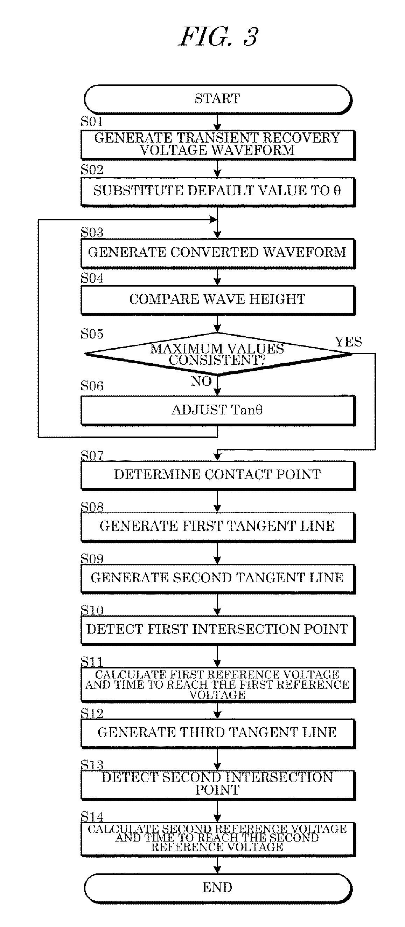

Next, a process of this embodiment will be explained with reference to a flowchart illustrated in FIG. 3. First, the waveform generation unit 11 generates a transient recovery voltage waveform based on a detected value of a transient recovery voltage stored in advance in the memory 20 or input from the exterior (step 01). A transient recovery voltage waveform generated and stored in the memory 20 in advance may also be utilized. The adjustment unit 122 of the waveform conversion unit 12 substitutes a default value to $\theta$ in the formula (1) of the generation unit 121 (step 02). The generation unit 121 converts the transient recovery voltage waveform through the formula (1) (step 03).

The wave height determination unit 13 determines the maximum value (peak value) in the converted waveform, and compares and determines whether or not there is a point indicating a value consistent with this maximum value (step 04). When the wave height determination unit 13 determines that there is no corresponding value (step 05: NO), the adjustment unit 122 changes the value of $\theta$ in accordance with a predetermined standard, thereby adjusting $\mathrm{Tan}\theta$ in the formula (1) (step 06). Subsequently, the processes from the step 03 to the step 06 are repeated.

In step 05, when the wave height determination unit 13 determines that there is a consistent value with the maximum value (step 05: YES), the contact point detection unit 14 detects two points (contact points) in the transient recovery voltage waveform corresponding to the two maximum values (step 07). This determination of the two points can be carried out by, for example, the time determination unit 14a and the contact point determination unit 14b set in the contact point detection unit 14 as explained above. That is, the time determination unit 14a obtains times of two points of the maximum value. Next, the contact point determination unit 14b determines two points in the transient recovery voltage waveform at these times.

Next, the tangent line generation unit 15 generates a straight line passing through the two contact points detected by the contact point detection unit 14 as a first tangent line (see L1 in FIG. 1 and $\gamma$ in FIG. 5) (step 08). Moreover, the tangent line generation unit 15 generates a tangent line running from the origin to the transient recovery voltage waveform as a second tangent line (see $\alpha$ in FIG. 5) (step 09). Subsequently, the intersection point detection unit 16 detects, as a first intersection point (see C1 in FIG. 5), an intersection point between the first tangent line and the second tangent line (step 10). Based on the first intersection point, the parameter calculation unit 17 calculates a first reference voltage and a time to reach the first reference voltage (or an initial rate of rise) (step 11).

Furthermore, the tangent line generation unit 15 generates a tangent line in parallel with the time axis at the second reference voltage as a third tangent line (see $\beta$ in FIG. 5) (step 12). Next, the intersection point detection unit 16 detects an intersection point between the first tangent line and the third tangent line as a second intersection point (see C2 in FIG. 5) (step 13). Based on the second intersection point, the parameter calculation unit 17 calculates a second reference voltage (already determined) and a time to reach the second reference voltage (step 14). Each calculated parameter is stored in the memory 20 in association with the transient recovery voltage waveform. These parameters become available when, for example, being output by the output unit 40 in accordance with the operation through the input unit 30.

[4. Advantage of Embodiment]

According to the above-explained embodiment, in a transient recovery voltage of a multiple frequency, a common tangent line drawn between a rise portion present between the wave height part and the origin, and, a rise portion corresponding to the wave height part can be generated through a simple process at a fast speed. Hence, the parameters of a four-parameter technique can be obtained at a fast speed.
In particular, the parameter to be adjusted is a part of θ, and a simple formula is utilized, and thus the load of arithmetic processing of a computer is little, enabling a fast-speed calculation. As explained above, when an angle is taken as an adjustment element, for example, as illustrated in FIG. 1, by indicating the angle between the tangent line L1 and the tangent line L2, it becomes easy to visually and intuitively grasp a change level.

[5. Other Embodiments]

The embodiment is not limited to the above-explained embodiment. For example, in the formula (1), when θ is eventually set, Tanθ can be regarded as a constant. Hence, the formula (1) can be modified into a following formula (2).
(Formula 2)

$$V_2 = V_1 - t \times \alpha \qquad \text{Formula (2)}$$

In this formula, $\alpha$ is a constant (proportional constant). That is, for example, even if a multiple of a time by the constant (proportional value) is subtracted from a transient recovery voltage, the waveform $V_2$ in FIG. 1 can be obtained, and thus the tangent line L1 can be generated.
For example, in the above-explained embodiment, the adjustment unit 122 of the waveform conversion unit 12 substitutes a default value to $\alpha$ (corresponding to step 02 in FIG. 3). Based on this operation, the generation unit 121 generates a waveform obtained by converting a transient recovery voltage waveform through the formula (2) (corresponding to step 03). The wave height determination unit 13 compares and determines whether or not there is a point indicating a value consistent with the maximum value (peak value) in the converted waveform (corresponding to step 04). When the wave height determination unit 13 determines that there is no consistent value (corresponding to step 05: NO), the adjustment unit 122 performs adjustment by changing the value of $\alpha$ in accordance with a predetermined standard (corresponding to step 06).
Accordingly, by simply taking an adjustment element as a proportional constant indicating a proportional value to a time, the calculation is simplified, thereby enabling fast-speed processing.
Moreover, the above-explained process procedures are not limited to the example illustrated in the flowchart in FIG. 3. In the above embodiment, for example, after the first tangent line is generated, the second tangent line and the third tangent line are generated. However, the second tangent line and the third tangent line with respect to a transient recovery voltage waveform may be generated in any stages. As far as there is at least a transient recovery voltage waveform, either one of or both of the second tangent line and the third tangent line may be generated prior to the generation of the first tangent line.
For example, the process in step 09 may be carried out after the process in step 01 in FIG. 3, and the processes in step 02 and in the subsequent steps may be carried out. After the process in step 01, the process in step 12 may be carried out, and the processes in step 02 and in the subsequent steps may be carried out. Moreover, after the process in step 01, the processes in step 09 and in step 12 may be carried out, and the processes in the step 02 and in the subsequent steps may be carried out. The detection of an intersection point may also be carried out collectively after all tangent lines are generated, not for every time the two tangent lines are generated.
The above-explained "rise portion" means to broadly include a part indicating up and down of a waveform, and can also be referred to as a "convex portion" and a "protruding portion", etc. Moreover, in the case of the opposite polarity, a portion that may be called a "hollow portion", a "concave portion", and a "recessed portion", etc., when a waveform is dimpled can be substantially the same as the above-explained "rise portion". When such a portion is reversed on a display screen, nothing is different between "rise" and "dimple".

Regarding a value (e.g., θ, α, and proportional constant) subjected to an adjustment by the adjustment unit, how to set a default value and a change level (e.g., an increment, a decrement, an increase, and a difference) is optional. For example, the process speed may be accelerated by increasing a change level, or the precision may be enhanced by decreasing the change level. Moreover, a change level may be set large at the time of the start of the process, and, as the process advances (e.g., after a predetermined time has elapsed, after a predetermined number of changes, and after a change by a predetermined change level), the change level may be decreased so as to optimize the process speed and the precision. When, for example, the polarity of a waveform is inverted, in a case in which a subtraction becomes an addition, and in a case in which a value of a constant to be changed not increases but decreases, substantially the same process is performed.

In the above-explained embodiment, the time determination unit 14a of the contact point detection unit 14 obtains times of the two points determined by the wave height determination unit 13, and the wave height determination unit 13 determines two points in a transient recovery voltage waveform corresponding to these times. A time and a clock time mean a horizontal axis (X axis) of two-dimensional coordinates. Hence, the determination process by the time determination unit 14a is the same as the determination process which determines a value in the horizontal axis corresponding to two points. That is, it is appropriate if the detection of a contact point by the contact point detection unit 14 can detect two points right above the two points (having the same value in the horizontal axis). Hence, it is appropriate if the contact point detection unit 14 carry out a process of obtaining two points on a transient recovery voltage waveform which have consistent values on the horizontal axis with the two points of the maximum value.

In the above-explained embodiment, after two points having the same maximum value are determined, two points on a transient recovery voltage waveform corresponding to these two points are obtained, and a tangent line passing through the obtained two points is generated. However, a first tangent line may be obtained from a tangent line (L2 in FIG. 1) passing through two points having the same maximum value. For example, a fourth tangent line generation unit which generates the tangent line L2 may be set in the above-explained tangent line generation unit 15. After the wave height determination unit 13 determines two points having the same maximum value, this fourth tangent line generation unit generates a fourth tangent line (the above-explained L2) passing through these two points. Subsequently, the first tangent line generation unit rotates this tangent line L2 by θ to obtain a first tangent line. In this way, when rotation is applied, the above-explained calculation using Tanθ becomes convenient.

In the above-explained embodiment, "measuring" of the measuring device and the measuring processing has a broad meaning which includes to obtain information for expressing a waveform. For example, collection, detection, generation, calculation, determination, and identification, etc., of various pieces of information are included. Hence, "measuring" also includes, for example, generation of a tangent line and a calculation of a parameter.

Accordingly, when focusing on the structure and processing of generating the first tangent line, the transient recovery voltage measuring device and the measuring processing in the above-explained embodiment can be expressed as a tangent line generation device, a tangent line generation method, and a tangent line generation program for a transient recovery voltage waveform. Example structures in the above-explained embodiment corresponding to those are the waveform generation unit 11 (or a memory storing a waveform generated in advance), the waveform conversion unit 12, the wave height determination unit 13, the contact point detection unit 14, and the tangent line generation unit 15, etc.

Moreover, when focusing on the structure and the processing which calculate a parameter for a four-parameter technique, the transient recovery voltage measuring device and the measuring processing in the above-explained embodiment can be expressed as a calculation device, a calculation method, and a calculation program for a parameter (parameter) of a transient recovery voltage. An example structure in the above-explained embodiment corresponding to those is the structure of the above-explained tangent line generation device to which the intersection point detection unit 16 and the parameter calculation unit 17 are added.

Furthermore, a waveform that is a target in the above-explained embodiment is not limited to a waveform of a transient recovery voltage, and any general waveforms are applicable. That is, the embodiment can be regarded as a tangent line generation device, a tangent line generation method and a tangent line generation program for a waveform in this case. An example structure in the above-explained embodiment corresponding to those is the one in which, in the above-explained tangent line generation device, a waveform generated by the waveform generation unit 11 (or a waveform generated in advance and stored in a waveform memory) is replaced with a general waveform (including a multiple frequency).

While certain embodiments have been described, these embodiments have been presented by way of example only, and are not intended to limit the scope of the inventions. Indeed, the novel methods and apparatuses described herein may be embodied in a variety of other forms; furthermore, various omissions, substitutions and changes in the form of the embodiments described herein may be made without departing from the spirit of the disclosures. The accompanying claims and their equivalents are intended to cover such forms or modifications as would fall within the scope and spirit of the inventions.

7

**Claims**

1. A transient recovery voltage measuring device comprising:

 a waveform memory that stores a transient recovery voltage waveform of a multiple frequency;
 a waveform conversion unit that converts the transient recovery voltage waveform based on a proportional value obtained by multiplying a time from an origin by a proportional constant;
 a wave height determination unit that determines two points having a same maximum value on a converted waveform;
 an adjustment unit that adjusts the proportional constant of the waveform conversion unit until two points having the same maximum value are determined by the wave height determination unit;
 a contact point detection unit that detects two points on the transient recovery voltage waveform corresponding to two points determined by the wave height determination unit; and
 a first tangent line generation unit that generates a first tangent line passing through the two points detected by the contact point detection unit.

2. The transient recovery voltage measuring device according to claim 1, wherein the waveform conversion by the waveform conversion unit is executed by subtracting the proportional value from the transient recovery voltage waveform.

3. The transient recovery voltage measuring device according to claim 2, wherein
 the proportional constant is a tangent, and
 the adjustment by the adjustment unit is executed by changing $\theta$ of the tangent.

4. The transient recovery voltage measuring device according to claim 1, wherein the waveform conversion by the waveform conversion unit is executed through a formula:

$$V_2 = V_1 - t \times \alpha$$

 where $V_1$ is a transient recovery voltage waveform, $V_2$ is a converted waveform, t is a time, and $\alpha$ is a proportional constant.

5. The transient recovery voltage measuring device according to claim 1, wherein the waveform conversion by the waveform conversion unit is executed through a formula:

$$V_2 = V_1 - t \times Tan\theta$$

 where $V_1$ is a transient recovery voltage waveform, $V_2$ is a converted waveform, t is a time, and $Tan\theta$ is a proportional constant.

6. The transient recovery voltage measuring device according to claim 1, wherein the contact point detection unit comprises:

 a time determination unit that determines two clock times of the two points determined by the wave height determination unit: and
 a contact point determination unit that determines two points on the transient recovery voltage waveform corresponding to the clock times determined by the time determination unit.

7. The transient recovery voltage measuring device according to claim 1, further comprising:

 a second tangent line generation unit that generates a tangent line drawn from an origin to the transient recovery voltage waveform;
 a first intersection point calculation unit that calculates an intersection point between the tangent line generated by the second tangent line generation unit and the  tangent line generated by the first tangent line generation unit; and

a parameter calculation unit that calculates a parameter of a transient recovery voltage based on the intersection point calculated by the first intersection point calculation unit.

8. The transient recovery voltage measuring device according to claim 1, further comprising:

a third tangent line generation unit that generates a tangent line in parallel with a time axis at a second reference voltage of the transient recovery voltage waveform;

a second intersection point calculation unit that calculates an intersection point between the tangent line generated by the third tangent line generation unit and the tangent line generated by the first tangent line generation unit; and

a parameter calculation unit that calculates a parameter of a transient recovery voltage based on the intersection point calculated by the second intersection point calculation unit.

9. A transient recovery voltage measuring device comprising:

a waveform memory that stores a transient recovery voltage waveform of a multiple frequency;

a waveform conversion unit that converts the transient recovery voltage waveform based on a proportional value obtained by multiplying a time from an origin by a proportional constant;

a wave height determination unit that determines two points having a same maximum value on a converted waveform;

an adjustment unit that adjusts the proportional constant of the waveform conversion unit until two points having the same maximum value are determined by the wave height determination unit; and

a first tangent line generation unit that generates a first tangent line between a rise portion present from an origin to a second reference voltage on the transient recovery voltage waveform and a rise portion corresponding to the second reference voltage based on two points determined by the wave height determination unit.

10. The transient recovery voltage measuring device according to claim 9, wherein the waveform conversion by the waveform conversion unit is executed by subtracting the proportional value from the transient recovery voltage waveform.

11. The transient recovery voltage measuring device according to claim 9, wherein

the proportional constant is a tangent, and

the adjustment by the adjustment unit is executed by changing $\theta$ of the tangent.

12. The transient recovery voltage measuring device according to claim 9, wherein the waveform conversion by the waveform conversion unit is executed through a formula:

$$V_2 = V_1 - t \times \alpha$$

where $V_1$ is a transient recovery voltage waveform, $V_2$ is a converted waveform, $t$ is a time, and $\alpha$ is a proportional constant.

13. The transient recovery voltage measuring device according to claim 9, wherein the waveform conversion by the waveform conversion unit is executed through a formula:

$$V_2 = V_1 - t \times \mathrm{Tan}\theta$$

where $V_1$ is a transient recovery voltage waveform, $V_2$ is a converted waveform, $t$ is a time, and $\mathrm{Tan}\theta$ is a proportional constant.

14. The transient recovery voltage measuring device according to claim 9, wherein the first tangent line generation unit generates the first tangent line based on a tangent line passing through the two points determined by the wave height determination unit.

**15.** The transient recovery voltage measuring device according to claim 9, further comprising:

a second tangent line generation unit that generates a tangent line drawn from an origin to the transient recovery voltage waveform;

a first intersection point calculation unit that calculates an intersection point between the tangent line generated by the second tangent line generation unit and the tangent line generated by the first tangent line generation unit; and

a parameter calculation unit that calculates a parameter of a transient recovery voltage based on the intersection point calculated by the first intersection point calculation unit.

**16.** The transient recovery voltage measuring device according to claim 9, further comprising:

a third tangent line generation unit that generates a tangent line in parallel with a time axis at a second reference voltage of the transient recovery voltage waveform;

a second intersection point calculation unit that calculates an intersection point between the tangent line generated by the third tangent line generation unit and the tangent line generated by the first tangent line generation unit; and

a parameter calculation unit that calculates a parameter of a transient recovery voltage based on the intersection point calculated by the second intersection point calculation unit.

**17.** A transient recovery voltage measuring method being executed by a computer or an electronic circuit and comprising:

a waveform storing process for storing a transient recovery voltage waveform of a multiple frequency;

a waveform conversion process for converting the transient recovery voltage waveform based on a proportional value obtained by multiplying a time from an origin by a proportional constant;

a wave height determination process for determining two points having a same maximum value on a converted waveform;

an adjustment process for adjusting the proportional constant of the waveform conversion process until two points having the same maximum value are determined through the wave height determination process;

a contact point detection process for obtaining two points on a transient recovery voltage waveform corresponding to the two maximum values determined through the wave height determination process; and

a first tangent line generation process for generating a first tangent line passing through the two points on the transient recovery voltage waveform.

**18.** A transient recovery voltage measuring method being executed by a computer or an electronic circuit and comprising:

a waveform storing process for storing a transient recovery voltage waveform of a multiple frequency;

a waveform conversion process for converting the transient recovery voltage waveform based on a proportional value obtained by multiplying a time from an origin by a proportional constant;

a wave height determination process for determining two points having a same maximum value on a converted waveform;

an adjustment process for adjusting the proportional constant of the waveform conversion process until two points having the same maximum value are determined through the wave height determination process; and

a first tangent line generation process for generating a first tangent line between a rise portion present from an origin to a second reference voltage on the transient recovery voltage waveform and a rise portion corresponding to the second reference voltage based on the two points determined through the wave height determination process.

**19.** A transient recovery voltage measuring program which is executable by a computer and causes the computer to execute:

a waveform storing process for storing a transient recovery voltage waveform of a multiple frequency;

a waveform conversion process for converting the transient recovery voltage waveform based on a proportional value obtained by multiplying a time from an origin by a proportional constant;

a wave height determination process for detecting two points having a same maximum value on a converted waveform;

an adjustment process for adjusting the proportional constant of the waveform conversion process until two points having the same maximum value are determined through the wave height determination process;

a contact point detection process for obtaining two points on a transient recovery voltage waveform corresponding to the two maximum values detected through the wave height determination process; and

a first tangent line generation process for generating a first tangent line passing through the two points on the transient recovery voltage waveform.

20. A transient recovery voltage measuring program which is executable by a computer and causes the computer to execute:

a waveform storing process for storing a transient recovery voltage waveform of a multiple frequency;

a waveform conversion process for converting the transient recovery voltage waveform based on a proportional value obtained by multiplying a time from an origin by a proportional constant;

a wave height determination process for determining two points having a same maximum value on a converted waveform;

an adjustment process for adjusting the proportional constant of the waveform conversion process until two points having the same maximum value are determined through the wave height determination process; and

a first tangent line generation process for generating a first tangent line between a rise portion present from an origin to a second reference voltage on the transient recovery voltage waveform and a rise portion corresponding to the second reference voltage based on the two points determined by the wave height determination process.

## FIG. 1

## FIG. 2

<u>1</u> TRANSIENT RECOVERY VOLTAGE MEASURING DEVICE

## FIG. 3

```
            ┌──────────────────────────────┐
            │            START             │
            └──────────────────────────────┘
S01                        │
      ┌────────────────────▼─────────────────────┐
      │   GENERATE TRANSIENT RECOVERY            │
      │          VOLTAGE WAVEFORM               │
      └──────────────────────────────────────────┘
S02                        │
      ┌────────────────────▼─────────────────────┐
      │      SUBSTITUTE DEFAULT VALUE TO θ        │
      └──────────────────────────────────────────┘
S03                        │
      ┌────────────────────▼─────────────────────┐
      │        GENERATE CONVERTED WAVEFORM        │
      └──────────────────────────────────────────┘
S04                        │
      ┌────────────────────▼─────────────────────┐
      │           COMPARE WAVE HEIGHT             │
      └──────────────────────────────────────────┘
S05                        │
              ◇ MAXIMUM VALUES CONSISTENT? ◇  ── YES ──┐
S06                   │ NO                              │
      ┌────────────────▼──────────────────┐            │
      │          ADJUST Tanθ              │            │
      └───────────────────────────────────┘            │
S07                        │ ◄──────────────────────────┘
      ┌────────────────────▼─────────────────────┐
      │         DETERMINE CONTACT POINT           │
      └──────────────────────────────────────────┘
S08                        │
      ┌────────────────────▼─────────────────────┐
      │        GENERATE FIRST TANGENT LINE        │
      └──────────────────────────────────────────┘
S09                        │
      ┌────────────────────▼─────────────────────┐
      │       GENERATE SECOND TANGENT LINE        │
      └──────────────────────────────────────────┘
S10                        │
      ┌────────────────────▼─────────────────────┐
      │      DETECT FIRST INTERSECTION POINT      │
      └──────────────────────────────────────────┘
S11                        │
      ┌────────────────────▼─────────────────────┐
      │   CALCULATE FIRST REFERENCE VOLTAGE       │
      │ AND TIME TO REACH THE FIRST REFERENCE     │
      │                VOLTAGE                    │
      └──────────────────────────────────────────┘
S12                        │
      ┌────────────────────▼─────────────────────┐
      │        GENERATE THIRD TANGENT LINE        │
      └──────────────────────────────────────────┘
S13                        │
      ┌────────────────────▼─────────────────────┐
      │      DETECT SECOND INTERSECTION           │
      │                POINT                      │
      └──────────────────────────────────────────┘
S14                        │
      ┌────────────────────▼─────────────────────┐
      │  CALCULATE SECOND REFERENCE VOLTAGE       │
      │    AND TIME TO REACH THE SECOND           │
      │          REFERENCE VOLTAGE                │
      └──────────────────────────────────────────┘
                           │
            ┌──────────────▼───────────────┐
            │             END              │
            └──────────────────────────────┘
```

*FIG. 4*

FIG. 5

EP 2 667 206 A1

<table>
<tr><td colspan="2" align="center">**INTERNATIONAL SEARCH REPORT**</td><td>International application No.<br>PCT/JP2012/050629</td></tr>
</table>

A. CLASSIFICATION OF SUBJECT MATTER
*G01R19/00*(2006.01)i

According to International Patent Classification (IPC) or to both national classification and IPC

B. FIELDS SEARCHED

Minimum documentation searched (classification system followed by classification symbols)
G01R19/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 5-223905 A  (Hitachi, Ltd.),<br>03 September 1993 (03.09.1993),<br>entire text; all drawings<br>(Family: none) | 1-20 |
| A | JP 61-129589 A  (Hitachi, Ltd.),<br>17 June 1986 (17.06.1986),<br>entire text; all drawings<br>(Family: none) | 1-20 |

☐ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>10 April, 2012 (10.04.12) | Date of mailing of the international search report<br>24 April, 2012 (24.04.12) |
|---|---|
| Name and mailing address of the ISA/<br>Japanese Patent Office | Authorized officer |
| Facsimile No. | Telephone No. |

Form PCT/ISA/210 (second sheet) (July 2009)